# EUROPÄISCHE PATENTANMELDUNG

(11) **EP 4 692 010 A1**
(43) Veröffentlichungstag der Anmeldung: **11.02.2026**
(21) Anmeldenummer: 24192815.9
(22) Anmeldetag: 05.08.2024
(51) Int. Cl.: C03C 17/00, H10F 77/30

(54) **BEDRUCKTE GLASSCHEIBE ZUM KASCHIEREN VON SONNENENERGIENUTZUNGSEINRICHTUNGEN**

(71) Anmelder: Glas Trösch Holding AG, 6374 Buochs (CH)
(72) Erfinder: Synowczyk, Dr. Andreas, 4800 Zofingen (CH)
(74) Vertreter: Keller Schneider Patent- und Markenanwälte AG

(57) **Zusammenfassung**

Die Erfindung betrifft eine bedruckte Glasscheibe (1) zum Kaschieren von Sonnenenergienutzungseinrichtungen (101), insbesondere von Photovoltaikzellen (52), Photovoltaikmodulen (50) oder thermischen Sonnenkollektoren, wobei die Glasscheibe (2) mit einer Farbschicht (3), insbesondere einer keramischen Farbschicht, bedruckt ist, wobei die Farbschicht (3) Pigmente (4) enthält und eine Pigmentdichte im Bereich von 2 g/m² bis 28 g/m², insbesondere im Bereich von 2 g/m² bis 22 g/m², aufweist. Weiter betrifft die Erfindung ein Verfahren zum Herstellen einer erfindungsgemässen bedruckten Glasscheibe (1). Ausserdem betrifft die Erfindung eine Sonnenenergienutzungsanordnung (100), umfassend eine Sonnenenergienutzungseinrichtung (101), insbesondere eine oder mehrere Photovoltaikzellen (52), ein oder mehrere Photovoltaikmodule (50) oder ein oder mehrere thermische Sonnenkollektoren, sowie eine erfindungsgemässe bedruckte Glasscheibe (1) zum Kaschieren von Sonnenenergienutzungseinrichtungen (101), insbesondere von Photovoltaikzellen (52), Photovoltaikmodulen (50) oder thermischen Sonnenkollektoren, wobei die bedruckte Glasscheibe (1) auf einer Seite, insbesondere einer Hauptfläche, der Sonnenenergienutzungseinrichtung (101) angebracht ist, um die Sonnenenergienutzungseinrichtung (101) zu kaschieren. Weiter betrifft die Erfindung ein Verfahren zum Herstellen einer solchen Sonnenenergienutzungsanordnung (100).

## Beschreibung

### Technisches Gebiet

Die Erfindung betrifft eine bedruckte Glasscheibe zum Kaschieren von Sonnenenergienutzungseinrichtungen, insbesondere von Photovoltaikzellen, Photovoltaikmodulen oder thermischen Sonnenkollektoren, sowie ein Verfahren zum Herstellen einer solchen bedruckten Glasscheibe. Weiter betrifft die Erfindung eine Sonnenenergienutzungsanordnung, umfassend eine Sonnenenergienutzungseinrichtung, insbesondere eine oder mehrere Photovoltaikzellen, ein oder mehrere Photovoltaikmodule oder ein oder mehrere thermische Sonnenkollektoren, sowie eine erfindungsgemässe bedruckte Glasscheibe sowie ein Verfahren zum Herstellen einer solchen Sonnenenergienutzungsanordnung.

### Stand der Technik

Sonnenenergienutzungseinrichtungen sind in verschiedensten Formen und Varianten bekannt. Ein Beispiel einer Sonnenenergienutzungseinrichtung ist eine Photovoltaikzelle. Mit einer Photovoltaikzelle kann Strahlungsenergie, in der Regel Sonnenlicht, direkt in elektrische Energie umwandelt werden. Ein weiteres Beispiel einer Sonnenenergienutzungseinrichtung ist ein Photovoltaikmodul. Ein Photovoltaikmodul umfasst vorzugweise eine oder mehrere Photovoltaikzellen. Entsprechend kann auch mit einem Photovoltaikmodul Strahlungsenergie, in der Regel Sonnenlicht, direkt in elektrische Energie umwandelt werden. Ein weiteres Beispiel einer Sonnenenergienutzungseinrichtung ist ein thermischer Sonnenkollektor. Mit einem thermischen Sonnenkollektor kann Strahlungsenergie, in der Regel Sonnenlicht, in Wärmeenergie umgewandelt werden. Die damit erhaltene Wärmeenergie kann beispielsweise zur Heizung eines Gebäudes, zur Bereitstellung von Warmwasser, insbesondere Gebrauchswarmwasser, zur Wasserdesinfektion, zur Wasserentsalzung, etc. genutzt werden.

Sonnenenergienutzungseinrichtungen weisen eine Sonnenenergieaufnahmeoberfläche zur Aufnahme von Sonnenergie in der Form von Sonnenstrahlung auf. Für die Nutzung von Sonnenenergienutzungseinrichtungen zur Umwandlung von Sonnenenergie in elektrischen Strom oder in Wärmeenergie muss die jeweilige Sonnenenergienutzungseinrichtung zur Aufnahme der Sonnenenergie mit ihrer Sonnenenergieaufnahmeoberfläche freistehend angeordnet werden. Vorzugsweise wird die jeweilige Sonnenenergienutzungseinrichtung dabei mit ihrer Sonnenenergieaufnahmeoberfläche der Sonne zugewandt angeordnet. Aufgrund dieser Anordnung der jeweiligen Sonnenenergienutzungseinrichtung ist die Sonnenenergieaufnahmeoberfläche der jeweiligen Sonnenenergienutzungseinrichtung gut sichtbar.

In der Regel weist die Sonnenenergieaufnahmeoberfläche einer Sonnenenergienutzungseinrichtung eine dunkle Farbe wie beispielsweise Schwarz auf. Die Sonnenenergieaufnahmeoberfläche von Photovoltaikzellen beispielsweise weist nebst Bereichen mit einer schwarzen Farbe in der Regel auch dunkle, leicht bläulich schimmernde Bereiche sowie metallisch erscheinende Linien auf. Diese metallisch erscheinenden Linien sind elektrische Kontakte und sind funktionell bedingt. Sie leiten elektrischen Strom. Insgesamt weisen die Sonnenenergieaufnahmeoberflächen von Sonnenenergienutzungseinrichtungen damit ein optisch wenig ansprechendes Erscheinungsbild auf. Entsprechend wird der Einsatz von Sonnenenergienutzungseinrichtungen oftmals aus ästhetischen Gründen abgelehnt.

Besonders ausgeprägt ist diese Ablehnung aus ästhetischen Gründen bei der Anwendung von Photovoltaikmodulen in Gebäudefassaden. Diese Anwendung wird auch als BIPV-Anwendung bezeichnet, wobei "BIPV" für "building integrated photovoltaics" steht. In solchen BIPV-Anwendungen bilden ästhetische Aspekte eine entscheidende Rolle bei der Bewilligung von Bauprojekten.

Vor diesem Hintergrund ist die Idee bekannt, Sonnenenergienutzungseinrichtungen optisch zu kaschieren. So können beispielsweise Photovoltaikmodule, die in Gebäudefassaden oder auf Hausdächern eingesetzt werden, optisch kaschiert werden. Wie aus der CH 713 931 B1 der Hochschule Luzern Technik und Architektur bekannt ist, können hierzu farbige bedruckte Glasscheiben über den Photovoltaikmodulen montiert werden. Damit kann das typischerweise dunkle Erscheinungsbild von Photovoltaikmodulen optisch kaschiert werden.

Ein derartiges optisches Kaschieren von Sonnenenergienutzungseinrichtungen mit einer bekannten, bedruckten Glasscheibe hat jedoch wirtschaftliche Nachteile. So ermöglichen derartig optisch kaschierte Sonnenenergienutzungseinrichtungen im Vergleich zu nicht kaschierten Sonnenenergienutzungseinrichtungen die Umwandlung von Sonnenenergie nur mit einer deutlich reduzierten Effizienz. Dadurch ist die wirtschaftliche Nutzbarkeit von optisch kaschierten Sonnenenergienutzungseinrichtungen reduziert.

Aus diesen Gründen ist der Anreiz zur Montage von Sonnenenergienutzungseinrichtungen in Gebäudefassaden gering. Bei optisch nicht kaschierten Sonnenenergienutzungseinrichtungen ist der Anreiz aufgrund von ästhetischen Gründen gering, während der Anreiz bei bekannten, mittels bedruckten Glasscheiben optisch kaschierten Sonnenenergienutzungseinrichtungen aufgrund der reduzierten Wirtschaftlichkeit gering ist.

Im vorliegenden Text bedeutet Kaschieren von Sonnenenergienutzungseinrichtungen vorzugsweise, dass optisch weniger oder gar nicht mehr Erkennbarmachen von Sonnenenergienutzungseinrichtungen. D.h., von einem Betrachter her gesehen hinter einer Glasscheibe zum Kaschieren von Sonnenergienutzungseinrichtungen angeordnete Sonnenenergienutzungseinrichtungen sind für den Betrachter optisch weniger oder gar nicht mehr als Sonnenenergienutzungseinrichtungen erkennbar.

Im vorliegenden Text wird an einigen Stellen die Formulierung "und/oder" zur Verknüpfung zweier Merkmale verwendet. Diese Formulierung bedeutet, dass wenigstens eines der zwei Merkmale verwirklicht ist. Dies kann auch so formuliert werden, dass entweder das eine der zwei Merkmale oder das andere der zwei Merkmale verwirklicht ist oder dass die zwei Merkmale zusammen verwirklicht sind.

### Darstellung der Erfindung

Aufgabe der Erfindung ist es, eine dem eingangs genannten technischen Gebiet zugehörende bedruckte Glasscheibe zu schaffen, welche ein optisches Kaschieren von Sonnenenergienutzungseinrichtungen bei zugleich wirtschaftlichen Nutzung der mit der bedruckten Glasscheibe optisch kaschierten Sonnenenergienutzungseinrichtungen ermöglicht. Weiter ist Aufgabe der Erfindung, ein Verfahren zur Herstellung einer solchen bedruckten Glasscheibe zu schaffen.

Die Lösung der Aufgabe ist durch die Merkmale des Anspruchs 1 definiert. Gemäss der Erfindung ist die Glasscheibe mit einer Farbschicht, insbesondere einer keramischen Farbschicht, bedruckt, um ein optisches Kaschieren von Sonnenenergienutzungseinrichtungen zu ermöglichen, wobei die Farbschicht Pigmente enthält und eine Pigmentdichte im Bereich von 2 g/m² bis 28 g/m², bevorzugt im Bereich von 2 g/m² bis 22 g/m², aufweist.

Erfindungsgemäss ist die Glasscheibe somit mit einer Farbschicht, insbesondere einer keramischen Farbschicht, bedruckt. Dadurch wird ein optisches Kaschieren von Sonnenenergienutzungseinrichtungen ermöglicht. Entsprechend ist die Farbschicht eine Sonnenenergienutzungseinrichtungen kaschierende Farbschicht. Dabei enthält die Farbschicht erfindungsgemäss Pigmente. Pigmente sind vorzugsweise Farbmittel, also farbgebende Substanzen, welche im Anwendungsmedium praktisch unlöslich sind und im Anwendungsmedium als Feststoff-Teilchen vorliegen. Erfindungsgemäss weist die Farbschicht eine Pigmentdichte im Bereich von 2 g/m² bis 28 g/m², bevorzugt im Bereich von 2 g/m² bis 22 g/m², auf. Im vorliegenden Text bedeutet eine Pigmentdichte in Bezug auf eine Farbschicht vorzugsweise die Masse der Pigmente in der Farbschicht pro mit der Farbschicht bedeckte Fläche. Eine Pigmentdichte von 10 g/m² bedeutet somit vorzugsweise, dass eine Farbschicht, welche eine Fläche von einem Quadratmeter bedeckt, 10 Gramm Pigmente enthält. Bevorzugt sind die Pigmente dabei in der Farbschicht im Wesentlichen homogen, besonders bevorzugt homogen, verteilt.

Gemäss der Erfindung wird im Verfahren zum Herstellen einer erfindungsgemässen bedruckten Glasscheibe eine Glasscheibe mit einer Farbschicht, insbesondere einer keramischen Farbschicht, bedruckt, um mit der resultierenden, bedruckten Glasscheibe ein optisches Kaschieren von Sonnenenergienutzungseinrichtungen mit der bedruckten Glasscheibe zu ermöglichen, wobei die Farbschicht Pigmente enthält und eine Pigmentdichte im Bereich von 2 g/m² bis 28 g/m², insbesondere im Bereich von 2 g/m² bis 22 g/m², aufweist.

Mit einer erfindungsgemässen bedruckten Glasscheibe wird ein optisches Kaschieren einer Sonnenenergienutzungseinrichtung ermöglicht, indem die Sonnenenergienutzungseinrichtung für einen Betrachter hinter der bedruckten Glasscheibe angeordnet wird. Aufgrund der Farbschicht, mit welcher die bedruckte Glasscheibe bedruckt ist, ist die hinter der Glasscheibe angeordnete Sonnenergienutzungseinrichtung nicht mehr oder zumindest viel schlechter als Sonnenenergienutzungseinrichtung zu erkennen. Damit ist die Sonnenergienutzungseinrichtung optisch kaschiert.

Indem die Farbschicht erfindungsgemäss eine Pigmentdichte im Bereich von 2 g/m² bis 28 g/m² aufweist, wird erreicht, dass eine gute optische Kaschierung von Sonnenenergienutzungseinrichtungen ermöglicht wird. Zudem wird die Leistung, welche von einer mit einer erfindungsgemässen bedruckten Glasscheibe optisch kaschierten Sonnenenergienutzungseinrichtung bei einer gegebenen Sonneneinstrahlung erbracht wird, im Vergleich zur Leistung, welche von dergleichen, nicht kaschierten Sonnenenergienutzungseinrichtung bei der gleichen gegebenen Sonneneinstrahlung erbracht wird, nur geringfügig reduziert. Somit wird durch die erfindungsgemässe bedruckte Glasscheibe eine gute optische Kaschierung von Sonnenenergienutzungseinrichtungen bei zugleich wirtschaftlicher Nutzung von mit der bedruckten Glasscheibe optisch kaschierten Sonnenenergienutzungseinrichtungen ermöglicht.

Indem die Farbschicht eine Pigmentdichte im Bereich von 2 g/m² bis 22 g/m² aufweist, wird dieser Vorteil zusätzlich verstärkt. So wird durch eine Pigmentdichte in diesem Bereich insbesondere bei guter optischen Kaschierung eine noch wirtschaftlichere Nutzung von mit der bedruckten Glasscheibe optisch kaschierten Sonnenenergienutzungseinrichtungen ermöglicht.

Vorzugsweise enthält die Farbschicht Pigmente eines weissen Pigments. Dies hat den Vorteil, dass eine Kaschierung von Sonnenenergienutzungseinrichtungen mit einer weissen Farbe oder, falls die Farbschicht auch weitere Pigmente einer oder mehreren weiteren Farben enthält, eine gute Kaschierung mit einer gewünschten Farbe ermöglicht wird, wobei zugleich eine wirtschaftliche Nutzung der kaschierten Sonnenenergienutzungseinrichtungen ermöglicht wird. Zudem haben weisse Pigmente in der Farbschicht den Vorteil, dass selbst bei zusätzlichen weiteren Pigmenten einer oder mehreren anderen Farben mit einer insgesamt vergleichsweise geringen Pigmentdichte eine gewünschte Farbe der Kaschierung erzielt werden kann. Beispiele für weisse Pigmente sind Pigmente Zinksulfid, Zinkoxid sowie Zirkoniumoxid.

Alternativ dazu besteht aber auch Möglichkeit, dass die Farbschicht keine Pigmente eines weissen Pigments, sondern nur andersfarbige Pigmente enthält.

Vorteilhafterweise enthält die Farbschicht Pigmente aus Zinksulfid. Dies hat den Vorteil, dass bereits mit einer geringen Pigmentdichte eine gute Kaschierung von Sonnenenergienutzungseinrichtungen ermöglicht wird. Mit einer geringen Pigmentdichte wird zugleich eine wirtschaftliche Nutzung der kaschierten Sonnenenergienutzungseinrichtungen ermöglicht.

Bevorzugt weisen die Pigmente aus Zinksulfid in der Farbschicht eine Pigmentdichte von im Bereich von 0.4 g/m² bis 5 g/m², besonders bevorzugt im Bereich 0.4 g/m² bis 2.5 g/m², auf. Dies hat den Vorteil, dass eine gute Kaschierung von Sonnenenergienutzungseinrichtungen bei zugleich wirtschaftlicher Nutzung der kaschierten Sonnenenergienutzungseinrichtungen ermöglicht wird. Wenn die Pigmente aus Zinksulfid in der Farbschicht eine Pigmentdichte von 5 g/m² oder weniger aufweisen, dann kann problemlos erreicht werden, dass die Leistung, welche von einer mit der bedruckten Glasscheibe optisch kaschierten Sonnenenergienutzungseinrichtung bei einer gegebenen Sonneneinstrahlung erbracht wird, im Vergleich zur Leistung, welche von der gleichen, nicht kaschierten Sonnenenergienutzungseinrichtung bei der gleichen gegebenen Sonneneinstrahlung erbracht wird, um kaum mehr als 30% oder weniger als 30% reduziert wird. Wenn die Pigmente aus Zinksulfid in der Farbschicht eine Pigmentdichte von 2.5 g/m² oder weniger aufweisen, dann kann problemlos erreicht werden, dass die Leistung, welche von einer mit der bedruckten Glasscheibe optisch kaschierten Sonnenenergienutzungseinrichtung bei einer gegebenen Sonneneinstrahlung erbracht wird, im Vergleich zur Leistung, welche von der gleichen, nicht kaschierten Sonnenenergienutzungseinrichtung bei der gleichen gegebenen Sonneneinstrahlung erbracht wird, um weniger als 25% reduziert wird. In den meisten Fällen kann damit sogar erreicht werden, dass die Leistung um weniger als 20% reduziert wird.

Vorzugsweise weist die Farbschicht nebst den Pigmenten aus Zinksulfid noch weitere Pigmente mit einer Pigmentdichte von mindestens 0.1 g/m² auf. Dies hat den Vorteil, dass die Farbe der Farbschicht der bedruckten Glasscheibe mit der Wahl der weiteren Pigmente nach Wunsch angepasst werden kann. Daher wird eine gute Kaschierung von Sonnenenergienutzungseinrichtungen mit verschiedenen, gewünschten Farben bei zugleich wirtschaftlicher Nutzung der kaschierten Sonnenenergienutzungseinrichtungen ermöglicht. Indem die Farbschicht die Pigmente aus Zinksulfid in der Farbschicht mit einer Pigmentdichte von im Bereich von 0.4 g/m² bis 5 g/m² bzw. im Bereich 0.4 g/m² bis 2.5 g/m² aufweist, wird mit einer geringen Pigmentdichte eine gute Kaschierung von Sonnenenergienutzungseinrichtungen erreicht. Da Zinksulfid eine weisse Farbe aufweist, wird mit den Pigmenten aus Zinksulfid eine weisse Grundlage für den Einsatz der weiteren Pigmente geschaffen, welche weisse Grundlage die ansonsten dunkle oder gar schwarze Farbe der Sonnenenergieaufnahmeoberflächen der Sonnenenergienutzungseinrichtungen gut kaschiert. Deshalb reicht eine vergleichsweise geringe Pigmentdichte der weiteren Pigmente aus, um die gewünschte Farbe beim Kaschieren der Sonnenenergienutzungseinrichtungen zu erzielen. Somit kann eine gute Kaschierung von Sonnenenergienutzungseinrichtungen mit verschiedenen Farben bei geringer Pigmentdichte erreicht werden. Aufgrund der insgesamt geringen Pigmentdichte wird zugleich eine besonders wirtschaftliche Nutzung der kaschierten Sonnenenergienutzungseinrichtungen ermöglicht.

Als Variante dazu besteht auch die Möglichkeit, dass die Farbschicht nur Pigmente aus Zinksulfid aufweist. Dabei kann bereits bei einer Pigmentdichte von 2.5 g/m² eine gute, weisse Kaschierung von Sonnenenergienutzungseinrichtungen erreicht werden. Die Leistung der Sonnenenergienutzungseinrichtungen wird dabei im Vergleich zum unkaschierten Zustand der Sonnenenergienutzungseinrichtungen nur um etwa 11% reduziert.

Alternativ zu diesen Varianten besteht aber auch die Möglichkeit, dass die Farbschicht keine Pigmente aus Zinksulfid enthält.

Unabhängig davon, ob die Farbschicht Pigmente aus Zinksulfid enthält oder nicht, ist die Farbschicht vorzugsweise basierend auf einer Mischung aus Pigmenten und Glasfritte gefertigt. Dies hat den Vorteil, dass durch geeignete Wahl des Anteil Pigmente und des Anteils Glasfritte auf einfache Art und Weise die gewünschte Pigmentdichte der Farbschicht erzielt werden kann.

Alternativ dazu besteht aber auch die Möglichkeit, dass die Farbschicht nicht basierend auf einer Mischung aus Pigmenten und Glasfritte gefertigt ist.

Bevorzugt befindet sich die Farbschicht auf einer Hauptfläche der bedruckten Glasscheibe, besonders bevorzugt auf genau einer Hauptfläche der bedruckten Glasscheibe. Entsprechend wird beim Herstellen der bedruckten Glasscheibe bevorzugt eine Hauptfläche der Glasscheibe, besonders bevorzugt genau eine Hauptfläche der Glasscheibe, mit der Farbschicht bedruckt.

Alternativ dazu besteht auch die Möglichkeit, dass sich die Farbschicht nicht auf einer Hauptfläche der bedruckten Glasscheibe befindet. In diesem Fall wird beim Herstellen der bedruckten Glasscheibe bevorzugt auch keine Hauptfläche der Glasscheibe mit der Farbschicht bedruckt.

Vorteilhafterweise wird zum Bedrucken der Glasscheibe mit der Farbschicht eine Druckpaste auf die Glasscheibe aufgedruckt, aus welcher Druckpaste die Farbschicht gebildet wird. Dies hat den Vorteil, dass die Glasscheibe auf effiziente und zuverlässige Weise mit der Farbschicht bedruckt werden kann. Zudem hat dies den Vorteil, dass durch geeignete Wahl der Zusammensetzung der Druckpaste die gewünschte Zusammensetzung der Farbschicht erzielt werden kann. So können beispielsweise Pigmente, welche in der Farbschicht enthalten sein sollen, in der gewünschten Menge der Druckpaste beigemischt werden. Auch können Pigmentgrundstoffe, aus welchen Pigmentgrundstoffen in der Farbschicht Pigmente gebildet werden sollen, in der gewünschten Menge der Druckpaste beigemischt werden. Wenn die Farbschicht beispielsweise Pigmente aus Zinkoxid enthalten soll und nach dem Bedrucken der Glasscheibe mit der Farbschicht die bedruckte Glasscheibe mit einer Wärmebehandlung, insbesondere einem thermischen Vorspannen, behandelt wird, so kann beispielsweise der Druckpaste Zinkcarbonat beigemischt werden. Bei der anschliessenden Wärmebehandlung (welche nachfolgend detaillierter beschrieben ist), entsteht in der Farbschicht unter Abscheidung von Kohlendioxid aus dem Zinkcarbonat Zinkoxid, welches ein weisses Pigment ist.

Vorzugsweise wird die Druckpaste auf der Hauptfläche, besonders bevorzugt auf der genau einen Hauptfläche, der Glasscheibe aufgedruckt.

Bevorzugt wird die Druckpaste mittels Walzendruck, Siebdruck oder Digitaldruck auf die Glasscheibe aufgedruckt. Dies hat den Vorteil, dass erfindungsgemässe bedruckte Glasscheiben mit grosser Effizienz hergestellt werden können. Walzendruck und Siebdruck haben dabei den besonderen Vorteil, dass Glasscheiben besonders effizient mit grossen, gleichmässigen Farbschichten bedruckt werden können. Entsprechend wird dadurch die Produktion von erfindungsgemässen bedruckten Glasscheiben in grossen Mengen ermöglicht. Digitaldruck hat demgegenüber den besonderen Vorteil, dass Glasscheiben effizient mit Farbschichten mit gewünschten Mustern bedruckt werden können.

Alternativ dazu besteht aber auch die Möglichkeit, dass die Glasscheibe mit einem anderen Druckverfahren als mit Walzendruck, Siebdruck oder Digitaldruck bedruckt wird.

Vorteilhafterweise beinhaltet die Druckpaste Pigmente oder Pigmentgrundstoffe, aus welchen Pigmentgrundstoffen Pigmente gebildet werden können, eine Glasfritte und ein flüssiges Druckmedium. Das flüssige Druckmedium kann beispielsweise auf einem Walzendrucköl oder einem Siebdrucköl basieren, d.h., vorzugsweise zu mindestens 80 Gewichtsprozent aus einem Walzendrucköl bzw. einem Siebdrucköl bestehen. Wenn die Druckpaste mittels Walzendruck auf die Glasscheibe aufgetragen wird, so basiert das flüssige Druckmedium vorzugsweise auf einem Walzendrucköl. Wenn die Druckpaste mittels Siebdruck auf die Glasscheibe aufgetragen wird, so basiert das flüssige Druckmedium vorzugsweise auf einem Siebdrucköl.

Als Siebdrucköl wird vorzugsweise eine Mischung von Polypropylenglykolen mit unterschiedlichen Molekulargewichten verwendet, insbesondere von Polypropylenglykolen mit einem Molekulargewicht von 400 g/mol und 100 g/mol.

Durch die Mischung von Polypropylenglykolen mit unterschiedlichen Molekulargewichten kann die Viskosität des Siebdrucköls variiert werden. Dadurch kann die Viskosität stets für die spezifische Anwendung auf einen optimalen Wert eingestellt werden. Insbesondere vorteilhaft hat sich eine Viskosität in der Grössenordnung von 10³ mPa s erwiesen.

Polypropylenglykol ist wasserlöslich, ungiftig und kaum umweltgefährdend, so dass die Verwendung von Polypropylenglykol als Basis des Siebdrucköls keine aufwändigen Sicherheitsvorkehrungen nötig macht.

Alternativ kann das Siebdrucköl jedoch auch ätherische Öle, insbesondere Pinienöl aufweisen.

Unabhängig davon, woraus das flüssige Druckmedium besteht, beinhaltet in einer besonders bevorzugten Variante die Druckpaste Flüssigkeit und Feststoffe, wobei die Pigmente, die Pigmentgrundstoffe, aus welchen Pigmentgrundstoffen die Pigmente gebildet werden können, und die Glasfritte die Feststoffe sind, während das Druckmedium die Flüssigkeit ist. Bevorzugt umfasst die Druckpaste etwa zwei Drittel Gewichtsanteile Feststoffe und etwa einen Drittel Gewichtsanteil Flüssigkeit, besonders bevorzugt zwei Drittel Gewichtsanteile Feststoffe und einen Drittel Gewichtsanteil Flüssigkeit. Dies ist ganz besonders vorteilhaft, wenn die Druckpaste mittels Walzendruck auf die Glasscheibe aufgedruckt wird, funktioniert aber auch sehr gut, wenn die Druckpaste mittels Siebdruck oder mittels Digitaldruck auf die Glasscheibe aufgedruckt wird.

In einer Variante davon besteht aber auch die Möglichkeit, dass der Anteil Flüssigkeit zu Feststoffen in der Druckpaste von etwa einem Drittel zu etwa zwei Drittel abweicht.

Vorzugsweise wird nach dem Bedrucken der Glasscheibe mit der Farbschicht die Farbschicht getrocknet. Vorzugsweise wird die Farbschicht bei 60°C getrocknet. Dies hat den Vorteil, dass anschliessende allfällige weitere Bearbeitungsschritte wie beispielsweise eine Wärmebehandlung zuverlässiger durchgeführt werden können, da die getrocknete Farbschicht während der anschliessenden allfälligen weiteren Bearbeitungsschritten keine Flüssigkeit mehr oder zumindest nur noch sehr geringe Mengen Flüssigkeit abgibt.

Alternativ dazu besteht aber auch die Möglichkeit, dass die Farbschicht nach dem Bedrucken der Glasscheibe nicht getrocknet wird.

Vorzugsweise besteht die Glasscheibe aus einem Glas der Liste Flachglas, Dünnglas und Flachglasdünnglas. Das Flachglas kann als Floatglas, Weissglas, Gussglas, Strukturglas oder geätztes Glas vorliegen. Ein Kalknatronglas kann beispielsweise als Dünnglas vorliegen. Ein eisenhaltiges Kalknatronglas ist beispielsweise ein Floatglas. Ein eisenarmes Kalknatronglas ist beispielsweise ein Weissglas. Ein Aluminosilikatglas kann beispielsweise als Flachglasdünnglas vorliegen. Aluminosilikatgläser sind per se eisenarm und damit Weissgläser.

Vorzugsweise wird als Glasscheibe eine im Floatglasverfahren hergestellte Glasscheibe verwendet. Insbesondere bevorzugt wird die Glasscheibe auf der Feuerseite der Floatglasscheibe mit der Farbschicht bedruckt. D.h., vorzugsweise ist die Hauptfläche oder die genau eine Hauptfläche der Glasscheibe die Feuerseite der Floatglasscheibe.

Vorteilhafterweise wird nach dem Bedrucken der Glasscheibe mit der Farbschicht sowie gegebenenfalls nach dem Trocknen der Farbschicht die bedruckte Glasscheibe mit einer Wärmebehandlung, insbesondere einem thermischen Vorspannen, behandelt. Thermisches Vorspannen beinhaltet nach einem Aufheizen der Glasscheibe für eine Zeitdauer vorzugsweise ein schnelles Abkühlen, insbesondere Abschrecken, der Oberfläche der Glasscheibe. Die fertig hergestellte bedruckte Glasscheibe kann somit beispielsweise ein Einscheiben-Sicherheitsglas (ESG) oder ein Teilvorgespanntes Glas (TVG) sein.

Die Wärmebehandlung hat den Vorteil, dass die Farbschicht dauerhaft mit der Glasscheibe verbunden wird. Insbesondere hat die Wärmebehandlung der bedruckten Glasscheibe den Vorteil, dass die Farbschicht eingebrannt werden kann, wodurch die Farbschicht fest mit der Glasscheibe verbunden wird. Entsprechend wird die Farbschicht kratzfester und alterungsbeständiger.

Bevorzugt wird für die Wärmebehandlung die Glasscheibe für eine Zeitdauer auf mindestens 500°C, besonders bevorzugt mindestens 600°C geheizt. Insbesondere wenn die Farbschicht basierend auf einer Mischung aus den Pigmenten und der Glasfritte gefertigt ist bzw. wenn zum Bedrucken der Glasscheibe mit der Farbschicht eine Druckpaste auf die Glasscheibe aufgedruckt wird, aus welcher Druckpaste die Farbschicht gebildet wird, und diese Druckpaste die Pigmente und die Glasfritte beinhaltet, dann wird der Vorteil erreicht, dass die Glasfritte geschmolzen wird, wodurch die Pigmente fest im daraus entstehenden Glas eingeschlossen und mit der Glasscheibe verbunden werden.

Vorzugsweise wird für die Wärmebehandlung die Glasscheibe für die Zeitdauer auf weniger als 1200°C geheizt.

Vorzugsweise beträgt die Zeitdauer mindestens 100 Sekunden, besonders bevorzugt mindestens 200 Sekunden. Vorteilhafterweise beträgt die Zeitdauer weniger als 1000 Sekunden.

Die Wärmebehandlung der Glasscheibe erfolgt besonders bevorzugt im Rahmen eines Fertigungsprozesses von Einscheiben-Sicherheitsgläsern (ESG). Bei diesem Fertigungsprozess wird eine Glasscheibe auf Temperaturen oberhalb der Transformationstemperatur erwärmt und anschliessend schlagartig wieder abgekühlt. Die Farbschicht kann dabei vor der Wärmebehandlung im Fertigungsprozess von ESG auf mindestens eine Oberfläche, insbesondere Hauptfläche der Glasscheibe aufgetragen werden. Dadurch lässt sich das vorliegende erfindungsgemässe Verfahren nahtlos in bestehende Fertigungsverfahren eingliedern. Dies hat den Vorteil, dass die Herstellung der erfindungsgemässen bedruckten Glasscheibe auf einfache Art und Weise in den gewöhnlichen Herstellungsprozess von Einscheiben-Sicherheitsgläsern (ESG) integriert werden kann.

Die Wärmebehandlung kann jedoch auch abseits eines allfälligen Fertigungsprozesses von Einscheiben-Sicherheitsgläsern (ESG) erfolgen.

Wenn nach dem Bedrucken der Glasscheibe mit der Farbschicht die bedruckte Glasscheibe mit der vorgehend beschriebenen Wärmebehandlung bzw. dem vorgehend beschriebenen thermischen Vorspannen behandelt wird, so wird der verwendeten Druckpaste vorzugsweise Zinkcarbonat (CAS 5263-02-5) und/oder Basisches Zirconium(IV)-Carbonat (CAS 57219-64-4) beigemischt. Zinkcarbonat (CAS 5263-02-5) ist ein Pigmentgrundstoff, aus welchem Pigmentgrundstoff bei Temperaturen über 50°C unter Abscheidung von 1.5 Gewichtsprozent Wasser sowie bei Temperaturen über 262°C unter Abscheidung von 25 Gewichtsprozent Kohlendioxid Zinkoxid-Pigmente gebildet werden. Basisches Zirconium(IV)-Carbonat (CAS 57219-64-4) hingegen ist ein Pigmentgrundstoff, aus welchem Pigmentgrundstoff bei Temperaturen über 84°C unter Abscheidung von 46 Gewichtsprozent Wasser bzw. Wasserdampf Zirkoniumoxid-Pigmente gebildet werden. Da die Temperaturen bei der Wärmebehandlung bzw. dem thermischen Vorspannen höher als 50°C bzw. 262°C bzw. höher als 84°C liegen, werden bei Zugabe von Zinkcarbonat (CAS 5263-02-5) bzw. Basischem Zirconium(IV)-Carbonat (CAS 57219-64-4) zur Druckpaste bei der Wärmebehandlung bzw. beim thermischen Vorspannen in der Farbschicht Zinkoxid-Pigmente bzw. Zirkonium-Pigmente gebildet. Zugleich erhält die Farbschicht aufgrund der Abscheidung von CO₂ bzw. von Wasser in beiden Fällen eine erhöhte Rauheit und werden Gasbläschen in der Farbschicht eingeschlossen, womit eine stark lichtstreuende keramische Glasoberfläche entsteht. Dies ermöglicht eine sehr gute optische Kaschierung von Sonnenenergienutzungseinrichtungen ohne grosse Leistungseinbusse der Sonnenenergienutzungseinrichtungen.

Für die Bemessung des Anteils Pigmentgrundstoff an der Druckpaste wird vorzugsweise die Abscheidung von Gas bzw. Wasser bei der Bildung der Pigmente Berücksichtigt. So wird vorzugsweise berücksichtigt, dass aus der Menge des gegebenenfalls beigegebenen Zinkcarbonats (CAS 5263-02-5) 73.5 Gewichtsprozent Zinkoxid gebildet werden. Weiter wird vorzugsweise berücksichtigt, dass aus der Menge des gegebenenfalls beigegebenen Basischen Zirconium(IV)-Carbonats (CAS 57219-64-4) 54 Gewichtsprozent Zirkoniumoxid gebildet werden.

Alternativ dazu kann aber auch auf die Zugabe von Zinkcarbonat und auf die Zugabe von Basischem Zirconium(IV)-Carbonat verzichtet werden.

Vorzugsweise wird die erfindungsgemässe bedruckte Glasscheibe in einer Sonnenenergienutzungsanordnung eingesetzt. Eine solche erfindungsgemässe Sonnenenergienutzungsanordnung umfasst vorteilhafterweise eine Sonnenenergienutzungseinrichtung, insbesondere eine oder mehrere Photovoltaikzellen, ein oder mehrere Photovoltaikmodule oder ein oder mehrere thermische Sonnenkollektoren, sowie eine erfindungsgemässe bedruckte Glasscheibe zum Kaschieren von Sonnenenergienutzungseinrichtungen, insbesondere von Photovoltaikzellen, Photovoltaikmodulen oder thermischen Sonnenkollektoren, wobei die bedruckte Glasscheibe auf einer Seite, insbesondere einer Hauptfläche, insbesondere der Sonnenenergieaufnahmeoberfläche, der Sonnenenergienutzungseinrichtung angebracht ist, um die Sonnenenergienutzungseinrichtung zu kaschieren. Damit bildet die Sonnenenergienutzungsanordnung eine kaschierte Sonnenenergienutzungseinrichtung.

In einer bevorzugten Variante davon ist die bedruckte Glasscheibe auf der Seite bzw. der Hauptfläche der Sonnenergienutzungseinrichtung auflaminiert. Dies hat den Vorteil, dass die Herstellung der Sonnenenergienutzungsanordnung vereinfacht wird.

Alternativ dazu besteht aber auch die Möglichkeit, dass die bedruckte Glasscheibe nicht auflaminiert, sondern andersartig auf der Seite bzw. der Hauptfläche der Sonnenergienutzungseinrichtung aufgebracht wird.

Vorzugsweise befindet sich die Farbschicht auf einer Hauptfläche der bedruckten Glasscheibe und ist die bedruckte Glasscheibe mit der Farbschicht der Sonnenenergienutzungseinrichtung zugewandt auf der Seite, insbesondere der Hauptfläche, insbesondere der Sonnenenergieaufnahmeoberfläche, der Sonnenenergienutzungseinrichtung, angebracht bzw. auflaminiert, um die Sonnenenergienutzungseinrichtung zu kaschieren. Dies hat den Vorteil, dass damit einerseits die Farbschicht vor äusseren Einflüssen geschützt zwischen Glasscheibe und Sonnenenergienutzungseinrichtung angeordnet ist und dass dadurch andererseits eine besonders gute kaschierende Wirkung der Sonnenenergienutzungseinrichtung erzielt werden kann.

Alternativ dazu besteht aber auch die Möglichkeit, dass die bedruckte Glasscheibe nicht mit der Farbschicht der Sonnenenergienutzungseinrichtung zugewandt auf der Seite, insbesondere der Hauptfläche, insbesondere der Sonnenenergieaufnahmeoberfläche, der Sonnenenergienutzungseinrichtung, angebracht bzw. auflaminiert ist, um die Sonnenenergienutzungseinrichtung zu kaschieren.

In einem Verfahren zum Herstellen der erfindungsgemässen Sonnenenergienutzungsanordnung wird eine erfindungsgemässe bedruckte Glasscheibe auf einer Seite, insbesondere einer Hauptfläche, insbesondere einer Sonnenenergieaufnahmeoberfläche einer Sonnenenergienutzungseinrichtung, insbesondere einer oder mehrerer Photovoltaikzellen, einem oder mehreren Photovoltaikmodule oder einem oder mehreren thermischen Sonnenkollektoren, angebracht bzw. auflaminiert, um die Sonnenenergienutzungseinrichtung zu kaschieren. Dies hat den Vorteil, dass eine optimal optisch kaschierte Sonnenenergienutzungseinrichtung erhalten werden kann, welche zugleich eine wirtschaftliche Nutzung erlaubt.

Vorzugsweise wird dabei die erfindungsgemässe bedruckte Glasscheibe mit dem erfindungsgemässen Verfahren zum Herstellen einer erfindungsgemässen bedruckten Glasscheibe hergestellt.

Vorzugsweise ist die bedruckte Glasscheibe auf einer Hauptfläche der bedruckten Glasscheibe mit der Farbschicht bedruckt und wird die bedruckte Glasscheibe mit der Farbschicht der Sonnenenergienutzungseinrichtung zugewandt auf der Seite, insbesondere der Hauptfläche, insbesondere der Sonnenenergieaufnahmeoberfläche der Sonnenenergienutzungseinrichtung, angebracht bzw. auflaminiert, um die Sonnenenergienutzungseinrichtung zu kaschieren.

Aus der nachfolgenden Detailbeschreibung und der Gesamtheit der Patentansprüche ergeben sich weitere vorteilhafte Ausführungsformen und Merkmalskombinationen der Erfindung.

### Kurze Beschreibung der Zeichnungen

Die zur Erläuterung der Ausführungsbeispiele verwendeten Figuren zeigen:
- Fig. 1: eine vereinfachte schematische Querschnittsdarstellung einer Sonnenenergienutzungsanordnung mit einer erfindungsgemässen bedruckten Glasscheibe,
- Fig. 2: eine vereinfachte schematische Querschnittsdarstellung der erfindungsgemässen bedruckten Glasscheibe aus Figur 1, und

- Fig. 3: eine stark vereinfachte, schematische Darstellung, um zu illustrieren, wie in einem erfindungsgemässen Verfahren zur Herstellung der erfindungsgemässen bedruckten Glasscheibe Druckpaste mittels Walzendruck auf eine Glasscheibe aufgedruckt werden kann, um die Glasscheibe mit einer Farbschicht zu bedrucken.

Grundsätzlich sind in den Figuren gleiche Teile mit gleichen Bezugszeichen versehen.

### Wege zur Ausführung der Erfindung

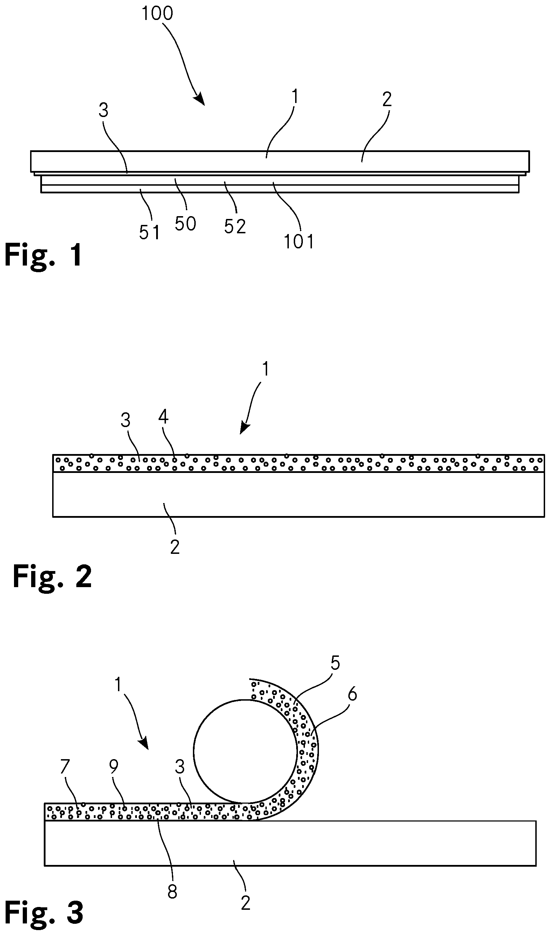

Figur 1 zeigt eine vereinfachte schematische Querschnittsdarstellung einer Sonnenenergienutzungsanordnung 100 mit einer erfindungsgemässen bedruckten Glasscheibe 1. Diese Sonnenenergienutzungsanordnung 100 umfasst nebst der bedruckten Glasscheibe 1 eine Sonnenenergienutzungseinrichtung 101. Im vorliegenden Beispiel ist die Sonnenenergienutzungseinrichtung 101 ein Photovoltaikmodul 50. Dieses umfasst eine Trägerglasscheibe 51, auf welcher mehrere, durch Kontakte miteinander verbundene Photovoltaikzellen 52 angeordnet sind. Derartige Photovoltaikmodule 50 sind bekannt und werden daher im vorliegenden Text nicht weiter beschrieben. In Varianten kann die Sonnenenergienutzungseinrichtung 101 aber auch anders ausgebildet sein. So kann die Sonnenenergienutzungseinrichtung 101 beispielweise durch mehrere Photovoltaikmodule gebildet sein. Sie kann aber beispielsweise auch eine oder mehrere Photovoltaikzellen oder ein oder mehrere thermische Sonnenkollektoren sein.

Wie in der Figur 1 zu erkennen ist, handelt es sich bei der erfindungsgemässen bedruckten Glasscheibe 1 um eine Glasscheibe 2, welche auf einer Hauptfläche mit einer Farbschicht 3 bedruckt ist. Dabei ist die bedruckte Glasscheibe 1 auf einer Hauptfläche der Sonnenenergienutzungseinrichtung 101, welche zugleich die Sonnenenergieaufnahmeoberfläche der Sonnenenergienutzungseinrichtung 101 ist, angebracht, um die Sonnenenergienutzungseinrichtung 101 zu kaschieren. Hierzu ist die bedruckte Glasscheibe 1 mit der Farbschicht 2 der Sonnenenergienutzungseinrichtung 101 zugewandt auf der Hauptfläche bzw. Sonnenenergieaufnahmeoberfläche der Sonnenenergienutzungseinrichtung 101 auflaminiert.

Die Sonnenenergienutzungsanordnung 100 kann beispielsweise in BIPV-Anwendungen genutzt werden. So kann sie an Hochbauten, d.h., Gebäuden, wie beispielsweise Wohnhäusern und Gewerbebauten, aber auch Silobauten, Brücken, Brückenstützen, Begrenzungsbauten wie Wänden zur Begrenzung von Grundstücken, Verkehrswegen wie Fussgängerwegen, Strassen, Autobahnen oder Eisenbahntrassen genutzt werden. Die Sonnenenergienutzungsanordnung 100 kann auch in Form von Ebenen wie Laufflächen, Gehwegflächen bzw. Fahrflächen und Treppenstufen oder als Bestandteil von Glas-Dächern genutzt werden. Vorzugsweise wird die Sonnenenergienutzungsanordnung 100 dabei so ausgerichtet montiert, dass die Sonnenenergienutzungseinrichtung 101 mit ihrer Sonnenenergieaufnahmeoberfläche dem Tageslicht, insbesondere der Sonne, zugewandt ist und dabei für den aussenstehenden Betrachter von der erfindungsgemässen bedruckten Glasscheibe 1 optisch kaschiert ist. D.h., bei einem Hochbau ist die Sonnenenergienutzungsanordnung 100 vorzugsweise mit der Sonnenenergienutzungseinrichtung 101 zum Hochbau hin und mit der erfindungsgemässen bedruckten Glasscheibe 1 vom Hochbau weg ausgerichtet am Hochbau montiert. Dadurch sieht der aussenstehende Betrachter des Hochbaus die Sonnenenergienutzungseinrichtung 101 nur durch die bedruckte Glasscheibe 1 hindurch. Entsprechend ist dadurch die Sonnenenergienutzungseinrichtung 101 durch die bedruckte Glasscheibe 1 kaschiert.

In der Darstellung der Figur 1 ist die Sonnenenergienutzungsanordnung 100 somit vorzugsweise mit ihrer in der Darstellung nach unten zeigenden Seite am Hochbau montiert, damit in der Darstellung der Figur 1 von oben kommende Sonnenstrahlung durch die erfindungsgemässe bedruckte Glasscheibe 1 mit der Farbschicht 3 zur Sonnenenergieaufnahmeoberfläche der Sonnenenergienutzungseinrichtung 101 dringen kann und damit die Sonnenenergienutzungseinrichtung 101 für einen sich in Darstellung oberhalb der Sonnenenergienutzungsanordnung 100 befindenden Betrachter optisch kaschiert ist.

Figur 2 zeigte eine vereinfachte schematische Querschnittsdarstellung der erfindungsgemässen bedruckten Glasscheibe 1. Im Gegensatz zur Figur 1 ist hier in der Figur 2 die Farbschicht 3 der bedruckten Glasscheibe 1 nicht mehr nach unten, sondern nach oben ausgerichtet dargestellt. Wie in der Figur 2 schematisch dargestellt, enthält die Farbschicht 3 Pigmente 4. Dabei können die Pigmente 4 eine einzige Art von Pigmenten oder verschiedene Arten von Pigmenten enthalten. Die Pigmentdichte in der Farbschicht 3 liegt jedoch insgesamt im Bereich von 2 g/m² bis 28 g/m², in einer bevorzugten Variante insgesamt im Bereich von 2 g/m² bis 22 g/m².

In einer bevorzugten Variante umfassen die Pigmente 4 weisse Pigmente wie beispielsweise Pigmente aus Zinksulfid und/oder Zinkoxid und/oder Zirkoniumoxid. In einer Variante, in welcher die Pigmente 4 Pigmente aus Zinksulfid enthalten, enthält in der Farbschicht 3 eine Pigmentdichte von Zinksulfid-Pigmenten im Bereich von 0.4 g/m² bis 5 g/m². In einer Variante davon enthält in der Farbschicht 3 eine Pigmentdichte von Zinksulfid-Pigmenten im Bereich 0.4 g/m² bis 2.5 g/m². In einer weiteren Variante, in welcher die Pigmente 4 Pigmente aus Zirkoniumoxid enthalten, enthält die Farbschicht 3 hingegen eine Pigmentdichte von Zirkoniumoxid-Pigmenten von 14 g/m².

Wenn mit der bedruckten Glasscheibe 1 die Sonnenenergienutzungseinrichtung 101 mit weisser Farbe kaschiert werden soll, dann besteht die Möglichkeit, dass die Pigmente 4 nebst den weissen Pigmenten keine weiteren Pigmente einer anderen Farbe enthält. Falls die Sonnenenergienutzungseinrichtung 101 hingegen mit einer anderen Farbe kaschiert werden soll, dann können die Pigmente 4 auch zusätzlich zu den weissen Pigmenten auch weitere Pigmente einer oder mehrerer anderen Farben enthalten. Dabei kann es sich bei den weiteren Pigmenten beispielsweise um blaue, gelbe, rote oder grüne Pigmente handeln. Sofern die Farbschicht 3 weitere, nicht weisse Pigmente enthält, enthält die Farbschicht 3 solche weitere Pigmente mit einer Pigmentdichte von mindestens 0.1 g/m². Es besteht aber auch die Möglichkeit, dass die Pigmente 4 keine weissen Pigmente, sondern nur Pigmente einer oder mehrerer anderen Farben enthalten.

In einem erfindungsgemässen Verfahren zur Herstellung einer erfindungsgemässen bedruckten Glasscheibe 1 zum Kaschieren von Sonnenenergienutzungseinrichtungen 101 wird eine Glasscheibe 2 mit der Farbschicht 3 bedruckt. Zum Bedrucken der Glasscheibe 2 mit der Farbschicht 3 wird eine Druckpaste 5 auf eine der Hauptflächen der Glasscheibe 2 aufgedruckt, aus welcher Druckpaste 5 letztlich die Farbschicht 3 gebildet wird. Im vorliegenden Ausführungsbeispiel ist die Glasscheibe 2 eine im Floatglasverfahren hergestellt Glasscheibe, wobei die Hauptfläche, auf welcher die Druckpaste 5 aufgedruckt wird, die Feuerseite der Floatglasscheibe ist. Wie in Figur 3 illustrativ dargestellt, kann die Druckpaste 5 dabei mittels Walzendruck auf die Glasscheibe 2 aufgedruckt werden. Anstelle von Walzendruck kann die Druckpaste 5 aber auch mittels Siebdruck, Digitaldruck oder mit einem anderen Druckverfahren auf die Glasscheibe 2 aufgedruckt werden.

In einem Ausführungsbeispiel, wo die Druckpaste 5 wie in der Figur 3 illustrativ dargestellt mittels Walzendruck auf die Glasscheibe 2 aufgedruckt wird, ist die Druckpaste 5 für das Aufdrucken mittels Walzendruck optimiert. Entsprechend enthält die Druckpaste 5 einen Gewichtsanteil flüssiges Druckmedium 6, vorliegend Walzendrucköl, sowie zwei Gewichtsanteile Feststoffe. Die Feststoffe werden durch Pigmente 9, allenfalls eingesetzte Pigmentgrundstoffe 7, sowie Glasfritte 8 gebildet. Die Anteile der Pigmente 9, eingesetzten Pigmentgrundstoffe 7 und Glasfritte können dabei nach Wunsch und Bedarf angepasst werden. Die letztlich in der fertiggestellten Farbschicht 3 enthaltenen Pigmente 4 umfassen dabei die allenfalls in der Druckpaste 5 enthaltenen Pigmente 9 sowie die aus den allenfalls in der Druckpaste 5 enthaltenen Pigmentgrundstoffen 7 gebildeten Pigmente. Wenn beispielsweise bekannt ist, dass die Druckpaste 5 mittels Walzendruck zu 140 g/m² auf die Glasscheibe 2 aufgedruckt wird, ist bei der vorliegend verwendeten Mischung von flüssigem Druckmedium und Feststoffen von einem Gewichtsanteil zu zwei Gewichtsanteilen bekannt, dass 93.33 g/m² Feststoffe auf die Glasscheibe 2 aufgedruckt werden. Wenn dabei 10 Gewichtsprozent der Feststoffe Pigmente 9 und 90 Gewichtsprozent der Feststoffe Glasfritte 8 sind, dann werden die Pigmente 4 in der Farbschicht 3 letztlich eine Pigmentdichte von 9.33 g/m² aufweisen. Wenn hingegen 10 Gewichtsprozent der Feststoffe Zinkcarbonat (CAS 5263-02-5) als Pigmentgrundstoff 7 sind, während 90 Gewichtsprozent der Feststoffe Glasfritte 8 sind, dann weist die auf die Hauptfläche der Glasscheibe 2 aufgedruckte Druckpaste 5 eine Zinkcarbonatdichte von 9.33 g/m² auf. Wenn die Glasscheibe 2 mit der aufgedruckten Druckpaste 5 anschliessend bei einer Temperatur von mehr als 262°C wärmebehandelt wird, so bilden sich aus dem Zinkcarbonat unter Abscheidung von 1.5 Gewichtsprozenz Wasser (ab einer Temperatur von mehr als 50°C) sowie unter Abscheidung von 25 Gewichtsprozent Kohlendioxid Zinkoxid-Pigmente. Diese Zinkoxid-Pigmente weisen somit letztlich in der fertig bedruckten Glasscheibe 1 in der Farbschicht 3 eine Pigmentdichte von 6.86 g/m² auf. Falls hingegen in der Druckpaste 5 10 Gewichtsprozent der Feststoffe Basisches Zirconium(IV)-Carbonat (CAS 57219-64-4) als Pigmentgrundstoff 7 sind, während 90 Gewichtsprozent der Feststoffe Glasfritte 8 sind, dann weist die auf die Hauptfläche der Glasscheibe 2 aufgedruckte Druckpaste 5 eine Dichte von 9.33 g/m² Basischem Zirconium(IV)-Carbonat auf. Wenn die Glasscheibe 2 mit der aufgedruckten Druckpaste 5 anschliessend bei einer Temperatur von mehr als 84°C wärmebehandelt wird, so bilden sich aus dem Basischen Zirconium(IV)-Carbonat unter Abscheidung von 46 Gewichtsprozent Wasser Zirkoniumoxid-Pigmente. Diese Zirkoniumoxid-Pigmente weisen letztlich in der fertig bedruckten Glasscheibe 1 in der Farbschicht 3 eine Pigmentdichte von 5.04 g/m² auf.

Unabhängig davon, ob die Druckpaste 5 Pigmente 9, Pigmentgrundstoffe 7 oder sowohl Pigmente 9 als auch Pigmentgrundstoffe 7 enthält, wird im vorliegenden Ausführungsbeispiel die mit der Druckpaste 5 als Farbschicht 3 bedruckte Glasscheibe 2 zuerst getrocknet. Hierzu wird die Farbschicht 3 bei 60°C getrocknet. Abschliessend wird die bedruckte Glasscheibe 2 thermisch vorgespannt und somit mit einer Wärmebehandlung behandelt. In einer ersten Variante wird die Glasscheibe 2 mit der Farbschicht 3 für 240 Sekunden auf 510°C aufgeheizt. In einer zweiten Variante wird die Glasscheibe 2 mit der Farbschicht 3 für 240 Sekunden auf 610°C aufgeheizt. In einer dritten Variante wird die Glasscheibe 2 mit der Farbschicht 3 für 240 Sekunden auf 1000°C aufgeheizt. In weiteren Varianten ist die Zeitdauer, für welche die Glasscheibe 2 mit der Farbschicht 3 aufgeheizt wird, kürzer, z.B. 100 Sekunden, oder länger, z.B. 500 Sekunden. Am Ende der Wärmebehandlung wird die Glasscheibe 2 mit der Farbschicht 3 schlagartig wieder abgekühlt. Diese Art von Wärmebehandlung ist ein thermisches Vorspannen. Dies ist bekannt, da mit diesem Verfahren Einscheiben-Sicherheitsglas (ESG) hergestellt wird. Somit ist im vorliegenden Ausführungsbeispiel die erfindungsgemässe bedruckte Glasscheibe 1 zugleich ein Einscheiben-Sicherheitsglas (ESG). Unabhängig davon, ob die ursprünglich aufgedruckte Druckpaste 5 Pigmente 9, Pigmentgrundstoffe 7 oder sowohl Pigmente 9 als auch Pigmentgrundstoffe 7 enthalten hat, ist die Farbschicht 3 letztlich basierend auf einer Mischung aus Pigmenten 4 und Glasfritte 8 gefertigt. Aufgrund der Wärmebehandlung ist die Glasfritte 8 aufgeschmolzen und hat die in der Druckpaste 5 vorhandenen Pigmente 9 und/oder die aus den in der Druckpaste 5 vorhandenen Pigmentgrundstoffen 7 gebildeten Pigmente eingeschlossen und fest mit der Glasscheibe 2 verbunden. Die Farbschicht 3 ist somit eine keramische Glasschicht. Falls die ursprünglich aufgedruckte Druckpaste 5 Pigmentgrundstoffe 7 enthalten hat, dann sind durch die Wärmebehandlung aus den Pigmentgrundstoffen 7 Pigmente entstanden, welche von den Pigmenten 4 in der Farbschicht 3 umfasst werden.

In einer Variante besteht auch die Möglichkeit, dass die mit der Druckpaste 5 als Farbschicht 3 bedruckte Glasscheibe 2 vor der Wärmebehandlung nicht getrocknet wird. Auch besteht die Möglichkeit, dass auf die Wärmebehandlung verzichtet wird. In diesem Fall wird die Farbschicht 3 direkt aus der auf der Glasscheibe 2 aufgedruckten Druckpaste 5 gebildet.

Um die in der Figur 1 dargestellte Sonnenenergienutzungsanordnung 100 herzustellen, wird anschliessend die die mit dem erfindungsgemässen Verfahren hergestellte erfindungsgemässe bedruckte Glasscheibe 1 mit der Farbschicht 3 der Sonnenenergienutzungseinrichtung 101 zugewandt auf der Hauptfläche bzw. Sonnenenergieaufnahmeoberfläche, der Sonnenenergienutzungseinrichtung 101 auflaminiert.

Verschiedene erfindungsgemässe bedruckte Glasscheiben 1 wurden mit dem vorgehend beschriebenen Verfahren hergestellt, indem eine Glasscheibe 2 mit einer Druckpaste 5 bedruckt, getrocknet und anschliessend thermisch vorgespannt wurde, um die Farbschicht 3 zu erzeugen. Dabei wurde die Druckpaste 5jeweils mittels Walzendruck mit 140 g/m² auf die Glasscheibe 2 gedruckt, wobei die Druckpaste 5 zu einem Gewichtsanteil aus Walzendrucköl als flüssiges Druckmedium sowie zu zwei Gewichtsanteile aus Feststoffen bestand. Die Feststoffe enthielten jeweils Glasfritte. Dabei wurde als Glasfritte ZnO-B₂O₃-SiO₂ der Firma Vibrantz GmbH aus Deutschland mit einer Korngrösse von 10 µm verwendet. Diese Glasfritte weist einen Schmelzbereich von 420°C bis 450°C auf. Zusätzlich zu der Glasfritte enthielten die Feststoffe jeweils Pigmente 9 oder Pigmentgrundstoffe 7.

Für diese bedruckten Glasscheiben 1 wurde jeweils die reduzierte Leistung eines Photovoltaikmoduls 50 bestimmt, wenn dieses Photovoltaikmoduls 50 als Sonnenenergienutzungseinrichtung 101 von der jeweiligen bedruckten Glasscheibe 1 kaschiert war. Dabei wurde die reduzierte Leistung in Prozent der Leistung des Photovoltaikmoduls 50 im nicht kaschierten Zustand bestimmt. Hierzu wurde für das Photovoltaikmodul 50 einmal im nicht kaschierten Zustand des Photovoltaikmoduls 50 und einmal im mit der jeweiligen bedruckten Glasscheibe 1 kaschierten Zustand des Photovoltaikmoduls 50 der Maximum Power Point des Photovoltaikmoduls 50 gemessen. Die reduzierte Leistung war dabei der Maximum Power Point im kaschierten Zustand in Prozent des Maximum Power Points im nicht kaschierten Zustand. Für diese Charakterisierung wurde das Photovoltaikmodul 50 nicht kaschiert sowie mit der jeweiligen bedruckten Glasscheibe 1 kaschiert mit einem handelsüblichen LED-Flasher, d.h. einer flächigen LED-Blitzlichtquelle, mit einer Blitzdauer von 160 ms vollständig ausgeleuchtet. Während dieser Blitzdauer wurde die Kennlinie des Photovoltaikmoduls 50 (Strom in A zur Spannung in V) gemessen. Der Maximum Power Point war dabei jeweils der Punkt auf der Kennlinie, an welchem Punkt das Produkt aus Spannung und Strom den grössten Wert annahm.

Für verschiedene bedruckte Glasscheiben 1 zur Kaschierung von Photovoltaikmodulen mit weisser oder grauer Farbe wurden folgende Werte erhalten:

### Weiss 1:

| | |
|---|---|
| 9.3 g/m² TiO₂ mit einer Korngrösse von 6.5 µm (weisses Pigment) | |
| Pigmentdichte in der Farbschicht insgesamt: | 9.3 g/m² |
| Kaschierte Erscheinung: | Transparent |
| Reduzierte Leistung: | 80% |

### Weiss 2:

| | |
|---|---|
| 2.3 g/m² ZnS (CAS 1314-98-3) mit einer Korngrösse von 1.0 µm (weisses Pigment) | |
| Pigmentdichte in der Farbschicht insgesamt: | 2.3 g/m² |
| Kaschierte Erscheinung: | Weiss-Transparent |
| Reduzierte Leistung: | 89% |

### Weiss 3:

| | |
|---|---|
| 2.8 g/m² CuO-Cr₂O₃-TiO₂ mit einer Korngrösse von 6.7 µm (dunkelgraues Pigment, Produkt Nr. 154001 der Firma Vibrantz GmbH) | |
| 0.93 g/m² ZnS (CAS 1314-98-3) mit einer Korngrösse von 1.0 µm (weisses Pigment) | |
| Pigmentdichte in der Farbschicht insgesamt: | 3.73 g/m² |
| Kaschierte Erscheinung: | Grau-Transparent |
| Reduzierte Leistung: | 86% |

### Weiss 4:

| | |
|---|---|
| 4.7 g/m² CuO-Cr₂O₃-TiO₂ mit einer Korngrösse von 6.7 µm (dunkelgraues Pigment, Produkt Nr. 154001 der Firma Vibrantz GmbH) | |
| Pigmentdichte in der Farbschicht insgesamt: | 4.7 g/m² |
| Kaschierte Erscheinung: | Grau-Transparent |
| Reduzierte Leistung: | 78% |

### Weiss 5:

| | |
|---|---|
| 2.8 g/m² CuO-Cr₂O₃-TiO₂ mit einer Korngrösse von 6.7 µm (dunkelgraues Pigment, Produkt Nr. 154001 der Firma Vibrantz GmbH) | |
| 1.9 g/m² TiO₂ mit einer Korngrösse von 6.5 µm (weisses Pigment) | |
| Pigmentdichte in der Farbschicht insgesamt: | 4.7 g/m² |
| Kaschierte Erscheinung: | Grau-Transparent |
| Reduzierte Leistung: | 88% |

### Weiss 6:

| | |
|---|---|
| 4.6 g/m² ZnS (CAS 1314-98-3) mit einer Korngrösse von 1.0 µm (weisses Pigment) | |
| Pigmentdichte in der Farbschicht insgesamt: | 4.6 g/m² |
| Kaschierte Erscheinung: | Weiss-Transparent |
| Reduzierte Leistung: | 68% |

Mit diesem letzten Beispiel mit 4.6 g/m² Zinksulfid ist gezeigt, dass die reduzierte Leistung des Photovoltaikmoduls bei 4.6 g/m² Zinksulfid auf unter 70% sinkt. Daher weisen die Pigmente aus Zinksulfid in der Farbschicht vorzugsweise eine Pigmentdichte von im Bereich von 0.4 g/m² bis 5 g/m², besonders bevorzugt im Bereich 0.4 g/m² bis 2.5 g/m² auf.

### Weiss 7:

| | |
|---|---|
| 13.7 g/m² ZnO (weisses Pigment; dieses Pigment wurde während dem thermischen Vorspannen erzeugt, indem der Druckpaste 20 Gewichtsprozent des Feststoffs Zinkcarbonat (CAS 5263-02-5) als Pigmentgrundstoff beigemischt wurde) | |
| Pigmentdichte in der Farbschicht insgesamt: | 13.7 g/m² |
| Kaschierte Erscheinung: | Weiss-Transparent |
| Reduzierte Leistung: | 86% |

### Weiss 8:

| | |
|---|---|
| 10.1 g/m² ZnO (weisses Pigment; dieses Pigment wurde während dem thermischen Vorspannen erzeugt, indem der Druckpaste 20 Gewichtsprozent des Feststoffs Basischen Zirconium(IV)-Carbonat (CAS 57219-64-4) als Pigmentgrundstoff beigemischt wurde) | |
| Pigmentdichte in der Farbschicht insgesamt: | 10.1 g/m² |
| Kaschierte Erscheinung: | Weiss-Transparent |
| Reduzierte Leistung: | 73% |

Für verschiedene bedruckte Glasscheiben 1 zur Kaschierung von Photovoltaikmodulen mit blauer Farbe wurden folgende Werte erhalten:

### Blau 1:

| | |
|---|---|
| 14 g/m² CoO-Al₂O₃ mit einer Korngrösse von 7.5 µm (blaues Pigment, Produkt Royablau, Nr. 124002, der Firma Vibrantz GmbH) | |
| 14 g/m² ZnO (CAS 1314-22-5) mit einer Korngrösse von 1 µm bis 5 µm (Weisses Pigment) | |
| Pigmentdichte in der Farbschicht insgesamt: | 28 g/m² |
| Kaschierte Erscheinung: | Blau-Transparent |
| Reduzierte Leistung: | 73% |

### Blau 2:

| | |
|---|---|
| 14 g/m² CoO-Al₂O₃ mit einer Korngrösse von 7.5 µm (blaues Pigment, Produkt Royablau, Nr. 124002, der Firma Vibrantz GmbH) | |
| 1.9 g/m² ZnS (CAS 1314-98-3) mit einer Korngrösse von 1.0 µm (weisses Pigment) | |
| Pigmentdichte in der Farbschicht insgesamt: | 15.9 g/m² |
| Kaschierte Erscheinung: | Blau-Transparent |
| Reduzierte Leistung: | 85% |

### Blau 3:

| | |
|---|---|
| 9.3 g/m² CoO-Al₂O₃ mit einer Korngrösse von 7.5 µm (blaues Pigment, Produkt Royablau, Nr. 124002, der Firma Vibrantz GmbH) | |
| 1.9 g/m² ZnS (CAS 1314-98-3) mit einer Korngrösse von 1.0 µm (weisses Pigment) | |
| Pigmentdichte in der Farbschicht insgesamt: | 11.2 g/m² |
| Kaschierte Erscheinung: | Blau-Transparent |
| Reduzierte Leistung: | 86% |

### Blau 4:

| | |
|---|---|
| 14 g/m² CoO-Al₂O₃ mit einer Korngrösse von 7.5 µm (blaues Pigment, Produkt Royablau, Nr. 124002, der Firma Vibrantz GmbH) | |
| 0.9 g/m² ZnS (CAS 1314-98-3) mit einer Korngrösse von 1.0 µm (weisses Pigment) | |
| Pigmentdichte in der Farbschicht insgesamt: | 14.9 g/m² |
| Kaschierte Erscheinung: | Blau-Transparent |
| Reduzierte Leistung: | 89% |

### Blau 5:

| | |
|---|---|
| 14 g/m² CoO-Al₂O₃ mit einer Korngrösse von 7.5 µm (blaues Pigment, Produkt Royablau, Nr. 124002, der Firma Vibrantz GmbH) | |
| 0.5 g/m² ZnS (CAS 1314-98-3) mit einer Korngrösse von 1.0 µm (weisses Pigment) | |
| Pigmentdichte in der Farbschicht insgesamt: | 14.5 g/m² |
| Kaschierte Erscheinung: | Blau-Transparent |
| Reduzierte Leistung: | 92% |

### Blau 6:

| | |
|---|---|
| 18.7 g/m² CoO-Al₂O₃ mit einer Korngrösse von 7.5 µm (blaues Pigment, Produkt Royablau, Nr. 124002, der Firma Vibrantz GmbH) | |
| 0.5 g/m² ZnS (CAS 1314-98-3) mit einer Korngrösse von 1.0 µm (weisses Pigment) | |
| Pigmentdichte in der Farbschicht insgesamt: | 19.2 g/m² |
| Kaschierte Erscheinung: | Blau-Transparent |
| Reduzierte Leistung: | 92% |

Für verschiedene bedruckte Glasscheiben 1 zur Kaschierung von Photovoltaikmodulen mit grüner Farbe wurden folgende Werte erhalten:

### Grün 1:

| | |
|---|---|
| 5.6 g/m² CoO-Al₂O₃ mit einer Korngrösse von 7.5 µm (blaues Pigment, Produkt Royablau, Nr. 124002, der Firma Vibrantz GmbH) | |
| 5.6 g/m² Cadmiumzinksulfidgelb, Cd-Zn-S (CAS 8048-07-5) mit einer Korngrösse von 7.5 µm, Produkt 134002CC der Firma Ceramic Colors Wolbring GmbH) | |
| 1.9 g/m² ZnS (CAS 1314-98-3) mit einer Korngrösse von 1.0 µm (weisses Pigment) | |
| Pigmentdichte in der Farbschicht insgesamt: | 13.1 g/m² |
| Kaschierte Erscheinung: | Grün-Transparent |
| Reduzierte Leistung: | 75% |

### Grün 2:

| | |
|---|---|
| 3.7 g/m² CoO-Al₂O₃ mit einer Korngrösse von 7.5 µm (blaues Pigment, Produkt Royablau, Nr. 124002, der Firma Vibrantz GmbH) | |
| 7.5 g/m² Pigmentbasis Cadmiumzinksulfidgelb, Cd-Zn-S (CAS 8048-07-5) mit einer Korngrösse von 7.5 µm, Produkt 134002CC der Firma Ceramic Colors Wolbring GmbH) | |
| 1.9 g/m² ZnS (CAS 1314-98-3) mit einer Korngrösse von 1.0 µm (weisses Pigment) | |
| Pigmentdichte in der Farbschicht insgesamt: | 13.1 g/m² |
| Kaschierte Erscheinung: | Grün-Transparent |
| Reduzierte Leistung: | 80% |

### Grün 3:

| | |
|---|---|
| 1.9 g/m² CoO-Al₂O₃ mit einer Korngrösse von 7.5 µm (blaues Pigment, Produkt Royablau, Nr. 124002, der Firma Vibrantz GmbH) | |
| 9.3 g/m² Pigmentbasis Cadmiumzinksulfidgelb, Cd-Zn-S (CAS 8048-07-5) mit einer Korngrösse von 7.5 µm, Produkt 134002CC der Firma Ceramic Colors Wolbring GmbH) | |
| 1.9 g/m² ZnS (CAS 1314-98-3) mit einer Korngrösse von 1.0 µm (weisses Pigment) | |
| Pigmentdichte in der Farbschicht insgesamt: | 13.1 g/m² |
| Kaschierte Erscheinung: | Grün-Transparent |
| Reduzierte Leistung: | 78% |

### Grün 4:

| | |
|---|---|
| 1.9 g/m² CoO-Al₂O₃ mit einer Korngrösse von 7.5 µm (blaues Pigment, Produkt Royablau, Nr. 124002, der Firma Vibrantz GmbH) | |
| 9.3 g/m² Pigmentbasis Cadmiumzinksulfidgelb, Cd-Zn-S (CAS 8048-07-5) mit einer Korngrösse von 7.5 µm, Produkt 134002CC der Firma Ceramic Colors Wolbring GmbH) | |
| 0.9 g/m² ZnS (CAS 1314-98-3) mit einer Korngrösse von 1.0 µm (weisses Pigment) | |
| Pigmentdichte in der Farbschicht insgesamt: | 12.1 g/m² |
| Kaschierte Erscheinung: | Grün-Transparent |
| Reduzierte Leistung: | 83% |

### Grün 5:

| | |
|---|---|
| 1.9 g/m² CoO-Al₂O₃ mit einer Korngrösse von 7.5 µm (blaues Pigment, Produkt Royablau, Nr. 124002, der Firma Vibrantz GmbH) | |
| 9.3 g/m² Zirkon-Praseodym-Silikat (CAS 68187-15-5) (gelbes Pigment, Produkt-Nr. 43870 der Firma Kremer Pigmente GmbH & Co KG) | |
| 0.9 g/m² ZnS (CAS 1314-98-3) mit einer Korngrösse von 1.0 µm (weisses Pigment) | |
| Pigmentdichte in der Farbschicht insgesamt: | 12.1 g/m² |
| Kaschierte Erscheinung: | Grün-Transparent |
| Reduzierte Leistung: | 84% |

### Grün 6:

| | |
|---|---|
| 1.9 g/m² CoO-Al₂O₃ mit einer Korngrösse von 7.5 µm (blaues Pigment, Produkt Royablau, Nr. 124002, der Firma Vibrantz GmbH) | |
| 9.3 g/m² Zirkonsilikat, ZrSiO₄/Pr (CAS 68187-15-5) mit einer Korngrösse von 10 µm bis 20 µm (gelbes Pigment, Produkt-Nr. 43880 der Firma Kremer Pigmente GmbH & Co KG) | |
| 0.9 g/m² ZnS (CAS 1314-98-3) mit einer Korngrösse von 1.0 µm (weisses Pigment) | |
| Pigmentdichte in der Farbschicht insgesamt: | 12.1 g/m² |
| Kaschierte Erscheinung: | Grün-Transparent |
| Reduzierte Leistung: | 85% |

Für verschiedene bedruckte Glasscheiben 1 zur Kaschierung von Photovoltaikmodulen mit roter Farbe wurden folgende Werte erhalten:

### Rot 1:

| | |
|---|---|
| 18.7 g/m² Pigmentbasis Cadmiumsulfoselinidrot, Cd-S-Se, (CAS 58339-34-7) mit einer Korngrösse von 7.1 µm (rotes Pigment, Produkt Nr. 174091 der Firma Vibrantz GmbH) | |
| Pigmentdichte in der Farbschicht insgesamt: | 18.7 g/m² |
| Kaschierte Erscheinung: | Rot-Transparent |
| Reduzierte Leistung: | 75% |

### Rot 2:

| | |
|---|---|
| 14 g/m² Pigmentbasis Cadmiumsulfoselinidrot, Cd-S-Se, (CAS 58339-34-7) mit einer Korngrösse von 7.1 µm (rotes Pigment, Produkt Nr. 174091 der Firma Vibrantz GmbH) | |
| Pigmentdichte in der Farbschicht insgesamt: | 14 g/m² |
| Kaschierte Erscheinung: | Rot-Transparent |
| Reduzierte Leistung: | 80% |

### Rot 3:

| | |
|---|---|
| 9.3 g/m² Pigmentbasis Cadmiumsulfoselinidrot, Cd-S-Se, (CAS 58339-34-7) mit einer Korngrösse von 7.1 µm (rotes Pigment, Produkt Nr. 174091 der Firma Vibrantz GmbH) | |
| Pigmentdichte in der Farbschicht insgesamt: | 9.3 g/m² |
| Kaschierte Erscheinung: | Rot-Transparent |
| Reduzierte Leistung: | 86% |

### Rot 4:

| | |
|---|---|
| 9.3 g/m² Fe₂O₃ (rotes Pigment) | |
| Pigmentdichte in der Farbschicht insgesamt: | 9.3 g/m² |
| Kaschierte Erscheinung: | Rot-Transparent |
| Reduzierte Leistung: | 85% |

### Rot 5:

| | |
|---|---|
| 7.5 g/m² Fe₂O₃ (rotes Pigment) | |
| 0.9 g/m² ZnS (CAS 1314-98-3) mit einer Korngrösse von 1.0 µm (weisses Pigment) | |
| Pigmentdichte in der Farbschicht insgesamt: | 8.4 g/m² |
| Kaschierte Erscheinung: | Rot-Transparent |
| Reduzierte Leistung: | 82% |

### Orange 1:

| | |
|---|---|
| 3.7 g/m² Fe₂O₃ (rotes Pigment) | |
| 3.7 g/m² Pigmentbasis Cadmiumzinksulfidgelb, Cd-Zn-S (CAS 8048-07-5) mit einer Korngrösse von 7.5 µm, Produkt 134002CC der Firma Ceramic Colors Wolbring GmbH) | |
| 1.9 g/m² ZnS (CAS 1314-98-3) mit einer Korngrösse von 1.0 µm (weisses Pigment) | |
| Pigmentdichte in der Farbschicht insgesamt: | 8.3 g/m² |
| Kaschierte Erscheinung: | Rot-Transparent |
| Reduzierte Leistung: | 77% |

Für verschiedene bedruckte Glasscheiben 1 zur Kaschierung von Photovoltaikmodulen mit brauner Farbe wurden folgende Werte erhalten:

### Braun 1:

| | |
|---|---|
| 5.6 g/m² Fe₂O₃ (rotes Pigment) | |
| 3.7 g/m² Pigmentbasis Cadmiumzinksulfidgelb, Cd-Zn-S (CAS 8048-07-5) mit einer Korngrösse von 7.5 µm, Produkt 134002CC der Firma Ceramic Colors Wolbring GmbH) | |
| 0.9 g/m² ZnS (CAS 1314-98-3) mit einer Korngrösse von 1.0 µm (weisses Pigment) | |
| Pigmentdichte in der Farbschicht insgesamt: | 10.2 g/m² |
| Kaschierte Erscheinung: | Braun-Transparent |
| Reduzierte Leistung: | 78% |

### Braun 2:

| | |
|---|---|
| 5.6 g/m² Fe₂O₃ (rotes Pigment) | |
| 3.7 g/m² Pigmentbasis Cadmiumzinksulfidgelb, Cd-Zn-S (CAS 8048-07-5) mit einer Korngrösse von 7.5 µm, Produkt 134002CC der Firma Ceramic Colors Wolbring GmbH) | |
| 0.5 g/m² ZnS (CAS 1314-98-3) mit einer Korngrösse von 1.0 µm (weisses Pigment) | |
| Pigmentdichte in der Farbschicht insgesamt: | 9.8 g/m² |
| Kaschierte Erscheinung: | Braun-Transparent |
| Reduzierte Leistung: | 82% |

### Braun 3:

| | |
|---|---|
| 5.6 g/m² Fe₂O₃ (rotes Pigment) | |
| 3.7 g/m² Zirkon-Praseodym-Silikat (CAS 68187-15-5) (gelbes Pigment, Produkt-Nr. 43870 der Firma Kremer Pigmente GmbH & Co KG) | |
| 0.5 g/m² ZnS (CAS 1314-98-3) mit einer Korngrösse von 1.0 µm (weisses Pigment) | |
| Pigmentdichte in der Farbschicht insgesamt: | 9.8 g/m² |
| Kaschierte Erscheinung: | Braun-Transparent |
| Reduzierte Leistung: | 82% |

### Braun 4:

| | |
|---|---|
| 5.6 g/m² Fe₂O₃ (rotes Pigment) | |
| 3.7 g/m² Zirkonsilikat, ZrSiO₄/Pr (CAS 68187-15-5) mit einer Korngrösse von 10 µm bis 20 µm (gelbes Pigment, Produkt-Nr. 43880 der Firma Kremer Pigmente GmbH & Co KG) | |
| 0.5 g/m² ZnS (CAS 1314-98-3) mit einer Korngrösse von 1.0 µm (weisses Pigment) | |
| Pigmentdichte in der Farbschicht insgesamt: | 9.8 g/m² |
| Kaschierte Erscheinung: | Braun-Transparent |
| Reduzierte Leistung: | 83% |

Für verschiedene bedruckte Glasscheiben 1 zur Kaschierung von Photovoltaikmodulen mit gelber Farbe wurden folgende Werte erhalten:

### Gelb 1:

| | |
|---|---|
| 18.7 g/m² Pigmentbasis Cadmiumzinksulfidgelb, Cd-Zn-S (CAS 8048-07-5) mit einer Korngrösse von 7.5 µm, Produkt 134002CC der Firma Ceramic Colors Wolbring GmbH) | |
| Pigmentdichte in der Farbschicht insgesamt: | 18.7 g/m² |
| Kaschierte Erscheinung: | Braun-Transparent |
| Reduzierte Leistung: | 86% |

### Gelb 2:

| | |
|---|---|
| 14 g/m² Pigmentbasis Cadmiumzinksulfidgelb, Cd-Zn-S (CAS 8048-07-5) mit einer Korngrösse von 7.5 µm, Produkt 134002CC der Firma Ceramic Colors Wolbring GmbH) | |
| 1.9 g/m² ZnS (CAS 1314-98-3) mit einer Korngrösse von 1.0 µm (weisses Pigment) | |
| Pigmentdichte in der Farbschicht insgesamt: | 15.9 g/m² |
| Kaschierte Erscheinung: | Braun-Transparent |
| Reduzierte Leistung: | 74% |

### Gelb 3:

| | |
|---|---|
| 18.7 g/m² Zirkonsilikat, ZrSiO₄/Pr (CAS 68187-15-5) mit einer Korngrösse von 10 µm bis 20 µm (gelbes Pigment, Produkt-Nr. 43880 der Firma Kremer Pigmente GmbH & Co KG) | |
| Pigmentdichte in der Farbschicht insgesamt: | 15.9 g/m² |
| Kaschierte Erscheinung: | Braun-Transparent |
| Reduzierte Leistung: | 90% |

### Gelb 4:

| | |
|---|---|
| 14 g/m² Zirkonsilikat, ZrSiO₄/Pr (CAS 68187-15-5) mit einer Korngrösse von 10 µm bis 20 µm (gelbes Pigment, Produkt-Nr. 43880 der Firma Kremer Pigmente GmbH & Co KG) | |
| 1.9 g/m² ZnS (CAS 1314-98-3) mit einer Korngrösse von 1.0 µm (weisses Pigment) | |
| Pigmentdichte in der Farbschicht insgesamt: | 15.9 g/m² |
| Kaschierte Erscheinung: | Braun-Transparent |
| Reduzierte Leistung: | 78% |

Die Erfindung ist nicht auf die vorgehend im Zusammenhang mit den Figuren beschriebenen Ausführungsbeispiele beschränkt. Weitere Ausführungsformen der Erfindung sind dem Fachmann durch Varianten und Variationen unmittelbar zugänglich.

Zusammenfassend ist festzustellen, dass eine dem eingangs genannten technischen Gebiet zugehörende bedruckte Glasscheibe geschaffen wird, welche ein optisches Kaschieren von Sonnenenergienutzungseinrichtungen bei zugleich wirtschaftlichen Nutzung der mit der bedruckten Glasscheibe optisch kaschierten Sonnenenergienutzungseinrichtungen ermöglicht. Weiter wird ein Verfahren zur Herstellung einer solchen bedruckten Glasscheibe geschaffen.

## Patentansprüche

1. Bedruckte Glasscheibe (1) zum Kaschieren von Sonnenenergienutzungseinrichtungen (101), insbesondere von Photovoltaikzellen (52), Photovoltaikmodulen (50) oder thermischen Sonnenkollektoren, **dadurch gekennzeichnet, dass** die Glasscheibe (2) mit einer Farbschicht (3), insbesondere einer keramischen Farbschicht, bedruckt ist, wobei die Farbschicht (3) Pigmente (4) enthält und eine Pigmentdichte im Bereich von 2 g/m² bis 28 g/m², insbesondere im Bereich von 2 g/m² bis 22 g/m², aufweist.

2. Bedruckte Glasscheibe (1) nach Anspruch 1, **dadurch gekennzeichnet, dass** die Farbschicht (3) Pigmente (4) aus Zinksulfid enthält.

3. Bedruckte Glasscheibe (1) nach Anspruch 2, **dadurch gekennzeichnet, dass** die Pigmente (4) aus Zinksulfid in der Farbschicht (3) eine Pigmentdichte von im Bereich von 0.4 g/m² bis 5 g/m², bevorzugt im Bereich 0.4 g/m² bis 2.5 g/m², aufweisen.

4. Bedruckte Glasscheibe (1) nach Anspruch 3, **dadurch gekennzeichnet, dass** die Farbschicht (3) nebst den Pigmenten (4) aus Zinksulfid noch weitere Pigmente (4) mit einer Pigmentdichte von mindestens 0.1 g/m² aufweist.

5. Verfahren zum Herstellen einer bedruckten Glasscheibe (1) nach einem der Ansprüche 1 bis 4 zum Kaschieren von Sonnenenergienutzungseinrichtungen (101), insbesondere von Photovoltaikzellen (52), Photovoltaikmodulen (50) oder thermischen Sonnenkollektoren, **dadurch gekennzeichnet, dass** eine Glasscheibe (2) mit einer Farbschicht (3), insbesondere einer keramischen Farbschicht, bedruckt wird, wobei die Farbschicht (3) Pigmente (4) enthält und eine Pigmentdichte im Bereich von 2 g/m² bis 28 g/m², insbesondere im Bereich von 2 g/m² bis 22 g/m², aufweist.

6. Verfahren nach Anspruch 5, **dadurch gekennzeichnet, dass** die Farbschicht (3) Pigmente (4) aus Zinksulfid enthält.

7. Verfahren nach Anspruch 6, **dadurch gekennzeichnet, dass** die Pigmente (4) aus Zinksulfid in der Farbschicht (3) eine Pigmentdichte von im Bereich von 0.4 g/m² bis 5 g/m², bevorzugt im Bereich 0.4 g/m² bis 2.5 g/m², aufweisen.

8. Verfahren nach einem der Ansprüche 5 bis 7, **dadurch gekennzeichnet, dass** zum Bedrucken der Glasscheibe (2) mit der Farbschicht (3) eine Druckpaste (5) auf die Glasscheibe (2) aufgedruckt wird, aus welcher Druckpaste (5) die Farbschicht (3) gebildet wird.

9. Verfahren nach Anspruch 8, **dadurch gekennzeichnet, dass** die Druckpaste (5) mittels Walzendruck, Siebdruck oder Digitaldruck auf die Glasscheibe (2) aufgedruckt wird.

10. Verfahren nach einem der Ansprüche 5 bis 9, **dadurch gekennzeichnet, dass** nach dem Bedrucken der Glasscheibe (2) mit der Farbschicht (3) die bedruckte Glasscheibe (2) mit einer Wärmebehandlung, insbesondere einem thermischen Vorspannen, behandelt wird.

11. Verfahren nach einem Anspruch 10, **dadurch gekennzeichnet, dass** für die Wärmebehandlung die Glasscheibe (2) für eine Zeitdauer auf mindestens 500°C, bevorzugt mindestens 600°C geheizt wird.

12. Sonnenenergienutzungsanordnung (100), umfassend eine Sonnenenergienutzungseinrichtung (101), insbesondere eine oder mehrere Photovoltaikzellen (52), ein oder mehrere Photovoltaikmodule (50) oder ein oder mehrere thermische Sonnenkollektoren, sowie eine bedruckte Glasscheibe (1) nach einem der Ansprüche 1 bis 4 zum Kaschieren von Sonnenenergienutzungseinrichtungen (101), insbesondere von Photovoltaikzellen (52), Photovoltaikmodulen (50) oder thermischen Sonnenkollektoren, wobei die bedruckte Glasscheibe (1) auf einer Seite, insbesondere einer Hauptfläche, der Sonnenenergienutzungseinrichtung (101) angebracht ist, um die Sonnenenergienutzungseinrichtung (101) zu kaschieren.

13. Sonnenenergienutzungsanordnung (100) nach Anspruch 12, **dadurch gekennzeichnet, dass** sich die Farbschicht (3) auf einer Hauptfläche der bedruckten Glasscheibe (1) befindet und die bedruckte Glasscheibe (1) mit der Farbschicht (3) der Sonnenenergienutzungseinrichtung (101) zugewandt auf der Seite, insbesondere der Hauptfläche, der Sonnenenergienutzungseinrichtung (101), angebracht ist, um die Sonnenenergienutzungseinrichtung (101) zu kaschieren.

14. Verfahren zum Herstellen einer Sonnenenergienutzungsanordnung (100) nach Anspruch 12 oder 13, wobei eine bedruckte Glasscheibe (1) nach einem der Ansprüche 1 bis 4 auf einer Seite, insbesondere einer Hauptfläche, einer Sonnenenergienutzungseinrichtung (101), insbesondere einer oder mehrerer Photovoltaikzellen (52), einem oder mehreren Photovoltaikmodule (50) oder einem oder mehreren thermischen Sonnenkollektoren, angebracht wird, um die Sonnenenergienutzungseinrichtung (101) zu kaschieren.

15. Verfahren nach Anspruch 14, **dadurch gekennzeichnet, dass** die bedruckte Glasscheibe (1) mit dem Verfahren nach einem der Ansprüche 5 bis 11 hergestellt wird.
